# EUROPÄISCHE PATENTSCHRIFT

(11) **EP 2 295 996 B1**
(45) Veröffentlichungstag und Bekanntmachung des Hinweises auf die Patenterteilung: **28.09.2011**
(21) Anmeldenummer: 09010228.6
(22) Anmeldetag: 07.08.2009
(51) Int. Cl.: G01R 31/06, G01R 31/12

(54) **System zur Überwachung eines Transformators**
System for monitoring a transformer
Système de surveillance d'un transformateur

(43) Veröffentlichungstag der Anmeldung: 16.03.2011
(73) Patentinhaber: Omicron electronics GmbH, 6833 Klaus (AT)
(72) Erfinder: Krüger, Michael, Dr., 6844 Altach (AT); Gockenbach, Ernst, Prof., 31303 Burgdorf (DE); Borsi, Hossein, Prof., 30519 Hannover (DE)
(74) Vertreter: Banzer, Hans-Jörg

(56) Entgegenhaltungen:
- WO-A1-96/13730
- DE-A1- 4 124 268
- US-A- 5 075 629
- US-A- 5 386 193
- US-A- 5 903 158

## Beschreibung

Die vorliegende Erfindung betrifft ein System zur Überwachung eines Transformators, insbesondere ein System zur Überwachung der Durchführungen, Kabelanschlüsse und eines Aktivteils des Transformators, sowie eine Messvorrichtung für einen Transformator, welche zur Verwendung in dem System zum Überwachen des Transformators geeignet ist.

Transformatoren, insbesondere große Leistungstransformatoren in Energieübertragungsnetzen oder Netzkoppler, sind häufig starken physikalischen Belastungen ausgesetzt, wie z.B. hohen Lastströmen oder inneren oder äußeren Kurzschlüssen. Dadurch können Beschädigungen insbesondere von Isolationen beispielsweise zwischen einzelnen Wicklungen oder innerhalb einer Wicklung durch z.B. eine Überlastung oder eine lsolationsalterung auftreten. Diese Schäden können schwerwiegende Folgen für die Betriebssicherheit des Transformators haben. Um den Zustand eines Transformators zu überwachen, werden daher regelmäßige Untersuchungen und Wartungen durchgeführt, wie z.B. eine Untersuchung des Transformatoröls oder elektrische Untersuchungen, wie z.B. eine Messung der Wicktungswiderstände oder eine Bestimmung des Verlustfaktors.

In diesem Zusammenhang wird in der WO 96/13730 ein System zum Erfassen einer Teilentladung in einem Hochspannungstransformator offenbart. Das System umfasst einen Metallkasten, welcher mit einem Behälter des Transformators lösbar verbunden ist, und einen ersten akustischen Sensor innerhalb des Kastens zum Umwandeln von akustischen Wellen in einem ersten Frequenzband in ein erstes elektrisches Ausgangssignal. Weiterhin umfasst das System einen Signalaufbereitungsschaltkreis innerhalb des Kastens, welcher mit dem ersten akustischen Sensor gekoppelt ist, wobei der Signalaufbereitungsschaltkreis das erste elektrische Signal verstärkt und filtert. Das System umfasst weiterhin einen elektro-optischen Wandler innerhalb des Kastens, welcher mit dem Signalaufbereitungsschaltkreis gekoppelt ist, um das verstärkte und gefilterte elektrische Signal in ein optisches Signal umzuwandeln. Weiterhin umfasst das System eine optische Faserverbindung zum Übertragen des optischen Signals von dem Transformator zu einer abgesetzten Stelle. Gemäß einer Ausführungsform umfasst das System weiterhin Mittel zum Erfassen eines elektrischen Signals, welches sich in einem Leiter, beispielsweise einer Wicklung des Transformators, ausbreitet und Mittel zum Inbezugsetzen des elektrischen Signals mit einem gleichzeitig erfassten akustischen Signal.

Weiterhin wird in der US 5,903,158 eine Vorrichtung zum Überwachen von Teilentladungen in einem elektrischen Leistungstransformator unter normalen Betriebsbedingungen offenbart. Die Vorrichtung umfasst einen induktiven Sensor mit mindestens einer Spule, welche an einer Hochspannungsdurchführung des Leistungstransformators angeordnet ist. Die Vorrichtung umfasst weiterhin einen kapazitiven Sensor, welcher an der Durchführung angeordnet ist, und eine Signalverarbeitungseinheit zum Empfangen von Ausgangssignalen von dem induktiven Sensor und dem kapazitiven Sensor und zum Ausbilden eines Ausgangssignals, welches dem Betrag einer internen Teilentladung in dem Transformator entspricht. Das Ausgangssignal wird einem Datenerfassungssystem zugeführt, welches außerhalb der Vorrichtung angeordnet ist.

Aufgabe der vorliegenden Erfindung ist es, eine verbesserte Überwachung für Transformatoren bereitzustellen, um eine Beschädigung eines Transformators frühzeitig erkennen zu können und somit einen Ausfall des Transformators und eine Beeinträchtigung der Energieübertragung des Energieübertragungsnetzes zu vermeiden.

Gemäß der vorliegenden Erfindung wird diese Aufgabe durch eine Messvorrichtung für einen Transformator nach Anspruch 1, ein System zum Überwachen eines Transformators nach Anspruch 14 und ein Verfahren zum Überwachen eines Transformators nach Anspruch 18 gelöst. Die abhängigen Ansprüche definieren bevorzugte und vorteilhafte Ausführungsformen der Erfindung.

Gemäß der vorliegenden Erfindung wird eine Messvorrichtung für einen Transformator bereitgestellt. Die Messvorrichtung umfasst ein Gehäuse, eine Verarbeitungseinheit, welche in dem Gehäuse untergebracht ist, einen Anschluss an dem Gehäuse zum Koppeln der Verarbeitungseinheit mit einem Erfassungsmittel zum Erfassen einer elektrischen Größe an einem Anschluss des Transformators und einen Daten-übertragungsanschluss zum Übertragen von Daten zwischen der Verarbeitungseinheit und einer externen Transformatorüberwachungseinrichtung. Weiterhin umfasst die Messvorrichtung eine Elektrode, welche beispielsweise plattenförmig ist. Die Elektrode ist an einer Außenfläche des Gehäuses der Messvorrichtung derart angebracht, dass die Elektrode, wenn die Messvorrichtung an dem Transformator angebracht ist, zusammen mit beispielsweise einer Hochspannungsleitung, welche mit dem Anschluss des Transformators gekoppelt ist, eine Kapazität bildet. Die Elektrode ist von dem Gehäuse galvanisch getrennt und mit der Verarbeitungseinheit gekoppelt. Die Elektrode bildet mit der Hochspannungsleitung eine Kapazität, die als Normalkondensator dienen kann. Der Anschluss des Transformators kann beispielsweise eine Durchführung durch ein Transformatorgehäuse des Transformators umfassen. Das Erfassungsmittel kann einen kapazitiven Messanschluss dieser Durchführung zur Erfassung einer Kapazität an der Durchführung oder einen Metallbelag auf einer Isolierung der Durchführung zur Erfassung einer Kapazität an der Durchführung umfassen. Die Kapazität des Normalkondensators und die Kapazität der Durchführung können die jeweiligen Hochspannungskondensatoren einer Messbrücke zur Messung der Veränderung der Kapazität und des Verlustfaktors der Durchführung bilden. Dadurch ist eine Überwachung und Diagnose dieser Durchführung möglich. Eine Veränderung der Kapazität der Durchführung ist beispielsweise ein Maß für eine mögliche Schädigung einer Isolierung oder für einen Ölmangel bei Öldurchführungen. Eine Veränderung des Verlustfaktors kann beispielsweise eine Alterung der Isolierung anzeigen. Die Verarbeitungseinheit kann derart ausgestaltet sein, dass sie die Kapazität, einen Verlustfaktor und/oder eine Teilentladung der Durchführung aus der erfassten elektrischen Größe und/oder einem Signal von der Elektrode bestimmt. Weiterhin kann die Messvorrichtung Befestigungsmittel zum Anbringen des Gehäuses an dem Transformator umfassen. Vorzugsweise wird die Messvorrichtung benachbart zu dem zu überwachenden Anschluss angebracht. Darüber hinaus kann das Gehäuse der Messvorrichtung elektromagnetisch geschirmt sein, so dass die Verarbeitungseinheit in dem Gehäuse vor elektromagnetischen Strahlen geschützt ist. Die Datenübertragung zwischen der Verarbeitungseinheit und der externen Transformatorüberwachungseinrichtung kann beispielsweise über eine optische Datenübertragung mit beispielsweise einem Lichtwellenleiter, wie z.B. einer Glasfaser oder einer Kunststofffaser, erfolgen. Die Messvorrichtung kann weiterhin eine Energieversorgungseinheit, wie z.B. eine Batterie oder einen Akkumulator, zum Versorgen der Messvorrichtung und insbesondere der Verarbeitungseinheit mit elektrischer Energie umfassen.

Indem die Messvorrichtung benachbart, beispielsweise in unmittelbarer Nähe zu dem Anschluss des Transformators angeordnet werden kann, kann eine Verbindung zwischen der Verarbeitungseinheit und dem Erfassungsmittel minimiert werden, wodurch Störungen der erfassten elektrischen Größe vermieden werden können. Weiterhin können elektrische Größen im Betrieb des Transformators erfasst werden und von der Verarbeitungseinheit vorverarbeitet werden. Die vorverarbeiteten Daten können beispielsweise in digitalisierter Form zu der Transformatorüberwachungseinrichtung übertragen werden. Mit Hilfe der optischen Datenübertragung wird vermieden, dass die Datenübertragung durch elektromagnetische Einstrahlungen, welche im Bereich von Transformatoren häufig auftreten, beeinträchtigt wird. Indem die Messvorrichtung eine eigene Energieversorgungseinheit umfasst, sind keine zusätzlichen Energieversorgungsleitungen von außerhalb der Messvorrichtung erforderlich, so dass über Energieversorgungsleitungen eingekoppelte Störungen vermieden werden können.

Gemäß einer Ausführungsform umfasst die Messvorrichtung einen Mikrofoneingang zum Koppeln der Verarbeitungseinheit mit einem an den Transformator angebrachten Mikrofon. Dadurch ist die Verarbeitungseinheit in der Lage, beispielsweise akustische Teilentladungssignale des Transformators zu erfassen und über den Datenübertragungsanschluss der externen Transformatorüberwachungseinrichtung zu übertragen.

Gemäß einer weiteren Ausführungsform umfasst die Messvorrichtung einen weiteren Mikrofoneingang zum Koppeln der Verarbeitungseinheit mit einem an dem Anschluss des Transformators angebrachten Mikrofons. Dadurch kann die Verarbeitungseinheit zusätzlich beispielsweise akustische Teilentladungssignale, welche in dem Anschluss des Transformators auftreten, erfassen und zu der Transformatorüberwachungseinrichtung übertragen. Die akustischen Signale können in der Verarbeitungseinheit mit den erfassten elektrischen Größen in Beziehung gesetzt werden und ein Ergebnis dieser Korrelation kann zu der Transformatorüberwachungseinrichtung übertragen werden. Dadurch kann das zu übertragende Datenvolumen verringert werden.

Gemäß einer weiteren Ausführungsform umfasst der Anschluss des Transformators einen Kabelanschluss des Transformators. Das Erfassungsmittel umfasst einen Hochfrequenzstromübertrager, welcher mit einem Kabel gekoppelt ist, welches an den Kabelanschluss des Transformators angeschlossen ist. Mit Hilfe des Hochfrequenzstromübertragers können beispielsweise Teilentladungssignale in dem Transformator oder dem Kabelanschluss erfasst werden. Dadurch ist eine Überwachung des Transformators auch auf der Seite der Kabelanschlüsse möglich.

Gemäß einer weiteren Ausführungsform umfasst die Messvorrichtung einen Signalgenerator zum Einspeisen eines Prüfsignals in den Transformator. Das Prüfsignal kann beispielsweise über das Erfassungsmittel, d.h. beispielsweise über den Messanschluss der Durchführung oder den Hochfrequenzstromübertrager, eingespeist werden. Durch Erfassen einer Signalantwort an Enden einer Wicklung des Transformators von z.B. der Messvorrichtung oder der Transformatorüberwachungseinrichtung kann eine Veränderung einer Übertragungsfunktion der Wicklung bestimmt werden. Die Änderung der Übertragungsfunktion kann ein Maß für eine mechanische Änderung innerhalb der Wicklung darstellen. Dadurch können Schäden in dem Transformator frühzeitig erkannt werden.

Gemäß der vorliegenden Erfindung wird weiterhin ein System zum Überwachen eines Transformators, welcher mehrere Anschlüsse umfasst, bereitgestellt. Das System umfasst mehrere der zuvor beschriebenen Messvorrichtungen, wobei jede Messvorrichtung benachbart zu jeweils einem Anschluss des Transformators angeordnet ist. Darüber hinaus umfasst das System eine Transformatorüberwachungseinrichtung. Die Transformatorüberwachungseinrichtung ist mit den mehreren Messvorrichtungen gekoppelt und ausgestaltet, aus einer Kombination der Daten von den mehreren Messeinrichtungen einen aktuellen Zustand des Transformators zu bestimmen. Der aktuelle Zustand kann beispielsweise eine Nennübersetzung des Transformators, eine Leistung des Transformators, eine Kurzschlussimpedanz des Transformators, eine Übertragungsfunktion einer Wicklung des Transformators, eine Teilentladung in dem Transformator oder eine Teilentladung an einem der mehreren Anschlüsse umfassen. Die mehreren Messvorrichtungen können mit der Transformatorüberwachungseinrichtung über optische Datenübertragungsteitungen gekoppelt sein, um eine Beeinflussung der übertragenen Daten durch eine elektromagnetische Einstrahlung zu vermeiden. Die mehreren Anschlüsse des Transformators können beispielsweise die Phasenanschlüsse des Transformators und einen Mittelpunktsleiter des Transformators umfassen. Indem Messungen an den Phasenanschlüssen und dem Mittelpunktsleiter des Transformators durchgeführt werden, kann beispielsweise ein Ort einer Teilentladung aus verschiedenen Teilentladungsmessungen an den verschiedenen Phasenanschlüssen und dem Mittelpunktsleiter bestimmt werden.

Gemäß der vorliegenden Erfindung wird weiterhin ein Verfahren zum Überwachen eines Transformators bereitgestellt. Bei dem Verfahren wird eine elektrische Größe an einem Anschluss des Transformators erfasst und die erfasste elektrische Größe in einer Messvorrichtung, welche benachbart zu dem Anschluss angeordnet wird, vorverarbeitet. Daten der vorverarbeiteten elektrischen Größe werden von der Messvorrichtung an eine zentrale Transformatorüberwachungseinrichtung übertragen. In der Transformatorüberwachungseinrichtung wird ein aktueller Zustand des Transformators aus den übertragenen Daten bestimmt.

Die elektrische Größe unfasst eine Kapazität zwischen einer Elektrode und einer Hochspannungsleitung, welche mit dem Anschluss des Transformators gekoppelt ist. Die Elektrode ist an einer Außenoberfläche des Gehäuses der Messvorrichtung der Hochspannungsleitung gegenüberliegend angebracht. Weiterhin kann die elektrische Größe eine Kapazität an dem Anschluss des Transformators umfassen. Das Übertragen der Daten von der Messvorrichtung zu der Transformatorüberwachungseinrichtung kann beispielsweise über optische Datenübertragungsleitungen, so genannte Lichtwellenleiter, erfolgen. Als Messvorrichtung kann beispielsweise die zuvor beschriebene Messvorrichtung verwendet werden. Das Verfahren ermöglicht somit einen aktuellen Zustand des Transformators im Betrieb zu bestimmen. Der aktuelle Zustand kann beispielsweise einen Zustand einer Isolation an Durchführungen des Transformators oder einen Verlustfaktor der Durchführungen oder Teilentladungen in dem Transformator oder in den Durchführungen umfassen. Da die Messvorrichtung benachbart zu dem Anschluss, z.B. einer Durchführung, des Transformators angeordnet ist, können die elektrischen Größen, wie z.B. eine Kapazität oder Teilentladungssignale, sehr genau erfasst werden und eine Störeinstrahlung auf diese Größen minimiert oder vermieden werden. Durch die Vorverarbeitung der erfassten elektrischen Größe kann eine zu übertragende Datenmenge verringert werden und eine digitale Übertragung, vorzugsweise eine digitale optische Übertragung über Lichtwellenleiter, durchgeführt werden, wodurch eine Verfälschung der Daten durch eine elektromagnetische Einstrahlung vermieden werden kann.

Gemäß einer Ausführungsform werden mehrere Messvorrichtungen an mehreren Anschlüssen des Transformators angeordnet und die mehreren Messvorrichtungen übertragen jeweils Daten von jeweiligen vorverarbeiteten elektrischen Größen an die zentrale Transformatorüberwachungseinrichtung. In der zentralen Transformatorüberwachungseinrichtung wird aus einer Kombination der Daten von den mehreren Messvorrichtungen ein aktueller Zustand des Transformators bestimmt. Durch Verknüpfen der Daten von den mehreren Messvorrichtungen kann der Zustand des Transformators bestimmt werden. Beispielsweise kann aus mehreren Teilentladungssignalen von mehreren Messvorrichtungen eine Ortung der Teilentladung in der Transformatorüberwachungseinrichtung durchgeführt werden.

Die vorliegende Erfindung wird nachfolgend unter Bezugnahme auf die Zeichnungen anhand bevorzugter Ausführungsformen erläutert werden.
Fig. 1 zeigt einen Leistungstransformator mit einer Durchführung und einer Messvorrichtung gemäß einer Ausführungsform der vorliegenden Erfindung.
Fig. 2 zeigt einen Leistungstransformator mit mehreren Durchführungen und mehreren Kabelanschlüssen, der mit einem System zum Überwachen des Transformators gemäß einer Ausführungsform der vorliegenden Erfindung ausgestattet ist.

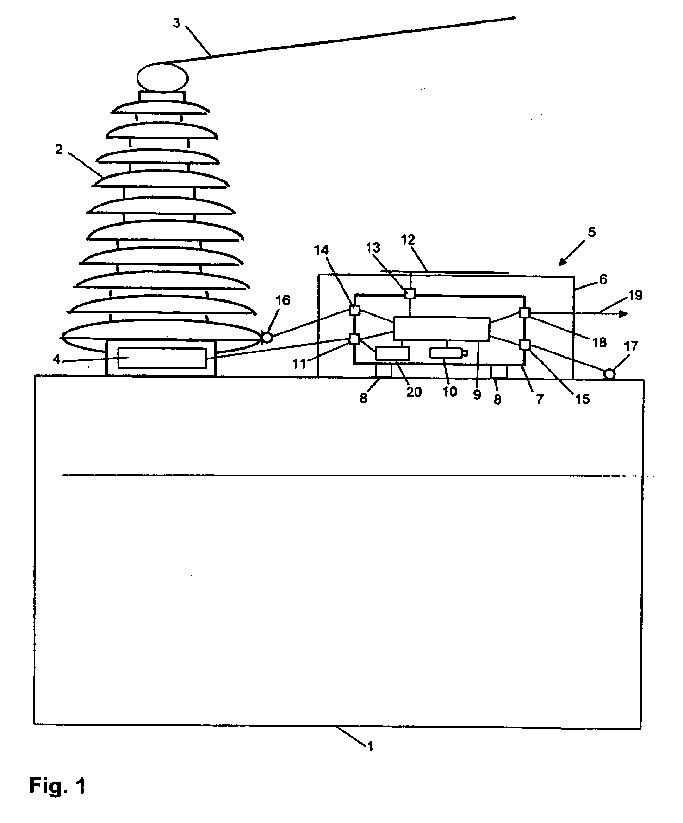

Fig. 1 zeigt einen Transformatorkessel eines Transformators 1 mit einer Durchführung 2, welche eine Hochspannungsleitung 3 mit dem Transformator 1 koppelt. An einem Fußpunkt der Durchführung 2 ist ein Erfassungsmittel bzw. Sensor 4 angebracht. Der Sensor 4 kann beispielsweise ein Messanschluss der Durchführung 2 sein. Die Kapazität zwischen Messanschluss und Innenleiter der Durchführung 2 kann beispielsweise 100-500 pF betragen. Alternativ kann das Erfassungsmittel 4 auch beispielsweise ein leitender Belag auf einer Isolierung der Durchführung 2 am Fußpunkt der Durchführung 2 sein, wodurch eine Kapazität zum Innenleiter der Durchführung 2 von beispielsweise einigen 10 pF erreicht werden kann

Benachbart zu der Durchführung 2 ist eine Messvorrichtung 5 auf dem Transformator 1 angeordnet. Die Messvorrichtung 5 umfasst ein Gehäuse, welches in der dargestellten Ausführungsform ein Doppelmantelgehäuse mit einem Außengehäuse 6 und einem Innengehäuse 7 umfasst. Das Außengehäuse 6 dient zum Schutz der Messeinrichtung gegen Witterungseinflüsse und Sonneneinstrahlung, wohingegen das Innengehäuse 7 mit einer elektromagnetischen Schirmung versehen ist, um eine Verarbeitungseinheit 9 im Inneren des inneren Gehäuses 7 vor elektromagnetischen Strahlen von beispielsweise der Hochspannungsleitung 3 und dem Transformator 1 zu schützen. Das Außengehäuse 6 kann teilweise offen ausgeführt sein, um eine Kühlung der Messvorrichtung 5 zu unterstützen. Das Gehäuse 6, 7 ist über Befestigungsmittel 8 an dem Transformator 1 benachbart zu der Durchführung 2 befestigt. Neben der Verarbeitungseinheit 9 befindet sich im Inneren des Innengehäuses 7 eine Batterie 10 zur Versorgung der Verarbeitungseinheit 9. Das Innengehäuse 7 und das Außengehäuse 6 sind elektrisch mit dem Transformator 1 verbunden und somit geerdet.

Auf der Oberseite des Außengehäuses 6 befindet sich von dem Außengehäuse 6 galvanisch getrennt eine beispielsweise plattenförmige Elektrode oder eine Schutzringelektrode, welche der Hochspannungsleitung 3 gegenüberliegt. Die Elektrode 12 bildet mit der Hochspannungsleitung 3 eine Kapazität, die als Normalkondensator dient. Über einen Elektrodenanschluss 13 ist die Elektrode 12 mit der Verarbeitungsreinheit 9 gekoppelt. An dem Innengehäuse 7 ist ferner ein Sensoranschluss 11 vorgesehen, über welchen die Verarbeitungseinheit 9 mit dem Sensor 4 an der Durchführung 2 gekoppelt ist. Damit ist die Verarbeitungseinheit 9 in der Lage, elektrische Signale des Normalkondensators, d.h. der Kombination aus Elektrode 12 und Hochspannungsleitung 3, und elektrische Signale des kapazitiven Sensors 4 der Durchführung 2 zu erfassen. Die Kapazität des Normalkondensators und die Kapazität der Durchführung 2 bilden die jeweiligen Hochspannungskondensatoren eine Messbrücke zur Messung der Veränderung der Kapazität und des Verlustfaktors der Durchführung 2, um diese Durchführung 2 zu überwachen. Eine Veränderung der Kapazität der Durchführung 2 kann ein Maß für eine mögliche Schädigung einer Isolierung der Durchführung 2 oder für einen Ölmangel bei Öldurchführungen sein. Die Änderung des Verlustfaktors zeigt eine Alterung der Isolierung der Durchführung 2 an. Um die elektrischen Größen der Kapazität der Durchführung 2 und des Normalkondensators zu bestimmen, umfasst die Verarbeitungseinheit 9 verschiedene elektronische Komponenten, wie z.B. eine Auskopplungsimpedanz, Verstärker und Filter. Darüber hinaus umfasst die Verarbeitungseinheit 9 beispielsweise eine Recheneinheit, welche die gemessenen elektrischen Größen digitalisiert und weiterverarbeitet und beispielsweise über einen elektrisch/optischen Konverter über einen Datenübertragungsanschluss 18 und einen Lichtwellenleiter 19 zu einer externen Transformatorüberwachungseinrichtung übertragt.

Damit kann die Verarbeitungseinheit 9 beispielsweise direkt in digitalisierter Form eine Information über eine Teilentladung oder einen Verlustfaktor der Durchführung 2 über den Datenübertragungsanschluss 18 ausgeben. Dazu kann beispielsweise eine Phasenrelation und eine Impulshöhe der gemessenen elektrischen Größen verwendet werden.

Neben den beschriebenen Messgrößen kann auch die Spannung an der Durchführung 2 gemessen werden. Da die Kapazität der Durchführung 2 oder auch die beschriebenen kapazitiven Messelektroden sehr kleine Induktivitäten haben, können auch schnell veränderliche Anteile der Spannung wie beispielsweise kurze Spannungsspitzen oder Einbrüche der Spannung erfasst werden. Die Messung dieser hochfrequenten Anteile der Spannung ist über Messwandler nicht möglich, da diese einen auf relativ niedrige Frequenzen eingeschränkten Übertragungsbereich aufweisen.

Neben der Spannung an der Durchführung 2 kann auch ein Strom durch die Durchführung 2 mit eingebauten Stromwandlern oder mit Hilfe von Stromsensoren wie beispielsweise Rogowski-Spulen erfasst werden.

Die Messvorrichtung 5 umfasst weiterhin zwei Mikrofonanschlüsse 14, 15, über welche zwei Mikrofone 16, 17 mit der Verarbeitungseinheit 9 gekoppelt werden. Das Mikrofon 16 ist an der Durchführung 2 angebracht und das Mikrofon 17 ist an dem Transformatorkessel 1 angebracht. Die Mikrofone 16, 17 dienen zur Erfassung von akustischen Teilentladungssignalen, welche von der Verarbeitungseinheit 9 zusammen mit den erfassten elektrischen Teilentladungssignalen vorverarbeitet und über den Datenübertragungsanschluss 18 ausgegeben werden. Darüber hinaus ist es beispielsweise mit dem Mikrofon 17 möglich, Geräusche eines (nicht gezeigten) Stufenschalters in dem Transformator 1 zu erfassen, um einen Zustand des Stufenschalters zu überwachen. Je nach Anwendung können auch weitere Mikrofone verwendet werden. Aus der Kombination dieser Werte kann beispielsweise eine Übersetzung und eine Abweichung zu einer dem Stufenschalter entsprechenden Nennübersetzung bestimmt und überwacht werden. Darüber hinaus können mit Hilfe der erfassten elektrischen Größen beispielsweise eine Leistung und eine Kurzschlussimpedanz bestimmt und überwacht werden.

Die Messvorrichtung 5 umfasst ferner einen Signalgenerator 20, welcher über den Sensoranschluss 11 mit dem Sensor 4 gekoppelt ist und von der Verarbeitungseinheit 9 angesteuert wird. Über den Sensor 4 sendet der Signalgenerator Signale in die Wicklung des Transformators. Eine Signalantwort an den Enden der Wicklung wird beispielsweise mit weiteren Messvorrichtungen erfasst. Mit Hilfe dieser Informationen bestimmt die Transformatorüberwachungseinrichtung eine Veränderung der Übertragungsfunktion der Wicklung, welche ein Maß für die mechanischen Änderungen innerhalb der Wicklung darstellt. Dadurch wird eine kontinuierliche Überwachung auch von mechanischen Änderungen innerhalb des Transformators sichergestellt. Darüber hinaus kann mit Hilfe der an der Durchführung 2 eingespeisten Signale von dem Signalgenerator 20 eine Kalibrierung für eine Teilentladungsmessung durchgeführt werden.

Schließlich kann die Messvorrichtung 5 weitere Anschlüsse für beispielsweise Temperatursensoren oder Drucksensoren aufweisen, um beispielsweise eine Öltemperatur des Transformators, einen Öldruck im Transformatorkessel des Transformators 1 und dergleichen zu bestimmen und zu überwachen.

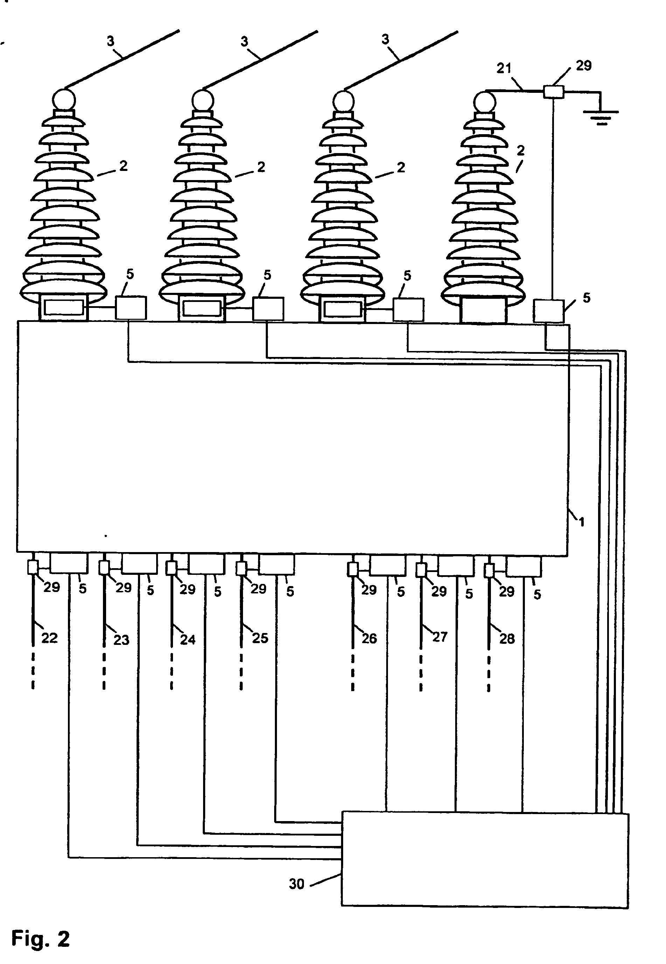

Fig. 2 zeigt eine weitere Ausführungsform der vorliegenden Erfindung. Ein Leistungstransformator 1 umfasst eine Oberspannungswicklung, eine Unterspannungswicklung und eine Tertiärwicklung. Die drei Phasenanschlüsse der Oberspannungswicklung sind über drei Durchführungen 2 mit entsprechenden Hochspannungsleitungen 3 gekoppelt (in Fig. 2 die drei links gezeigten Durchführungen 2). Der Mittelpunktsleiter der Oberspannungswicklung ist über eine weitere Durchführung 2 (in Fig. 2 rechts gezeigt) mit einem Erdungskabelanschluss 21 gekoppelt. Die drei Phasenanschlüsse der Unterspannungswicklung und der Mittelpunktsleiter der Unterspannungswicklung sind über Kabelanschlüsse 22-24 bzw. 25 angeschlossen. Die drei Phasenanschlüsse der Tertiärwicklung sind über Kabelanschlüsse 26-28 angeschlossen.

Die Überwachung der Durchführungen 2 für die drei Phasen der Oberspannungswicklung erfolgt, wie zuvor im Zusammenhang mit Fig. 1 beschrieben, mit Hilfe von drei Messvorrichtungen 5, welche jeweils einer Durchführung 2 zugeordnet sind. Den Kabelanschlüssen 21-28 ist auch jeweils eine Messvorrichtung 5 zugeordnet. Als Sensor zur Erfassung elektrischer Größen an den Kabelanschlüssen 21-28 werden Hochfrequenzstromübertrager 29 verwendet. Jedem Kabelanschluss 21-28 ist jeweils ein Hochfrequenzstromübertrager 29 zugeordnet und damit gekoppelt. Die Hochfrequenzstromübertrager 29 sind wiederum jeweils mit einer zugeordneten Messvorrichtung 5 gekoppelt.

Die Datenübertragungsanschlüsse 18 der Messvorrichtungen 5 sind über Lichtwellenleiter mit einer zentralen Transformatorüberwachungseinrichtung 30 gekoppelt. Dadurch stehen der zentralen Transformatorüberwachungseinrichtung 30 eine Vielzahl von Informationen bereit, um den Transformator 1 kontinuierlich im Betrieb zu überwachen und Fehlfunktionen frühzeitig zu erkennen. So können beispielsweise Teilentladungen sowohl in den Durchführungen 2 als auch in dem Transformator 1 selbst erkannt und lokalisiert werden. Darüber hinaus kann der Verlustfaktor der Durchführungen 2, die Spannung an den Durchführungen, die Ströme durch die Durchführungen sowie die Übertragungseigenschaften der Wicklungen bestimmt werden. Daraus können beispielsweise eine Übersetzung und eine Abweichung zu einer einem Stufenschalter entsprechenden Nennübersetzung, eine Leistung und eine Kurzschlussimpedanz berechnet und überwacht werden.

Statt der in Fig. 2 dargestellten Punkt-zu-Punkt-Verbindungen der Messvorrichtungen 5 mit der Transformatorüberwachungseinrichtung 30 kann auch ein Lichtwellenleiterbus mit beispielsweise zwei Einzelleitern (Transmit und Receive) verwendet werden, der von der Transformatorüberwachungseinrichtung 30 zum Eingang einer ersten Messvorrichtung 5 und vom Ausgang der ersten Messvorrichtung 5 zum Eingang einer zweiten Messvorrichtung 5 usw. verläuft.

Die Messvorrichtungen 5 der beiden äußeren Phasen, also beispielsweise in Fig. 2 die Messvorrichtung 5 der ganz links gezeigten Durchführung 2 und die Messvorrichtung 5 der dritten von links gezeigten Durchführung 2, werden vorzugsweise derart angeordnet, dass für diese beiden äußeren Phasen identische Normalkondensatoren zwischen den Elektroden 12 und den Hochspannungsleitungen 3 gebildet werden. Dadurch wird der Einfluss verschiedener Phasen minimiert. Darüber hinaus können anhand der Kapazitäten der gebildeten Normalkondensatoren die beiden äußeren Phasen durch Vergleich diagnostiziert werden. Phasenverschiebungen an den Elektroden 12 durch benachbarte Phasen oder andere Einflüsse können durch eine Kalibrierung mit genauen Messteilern oder Wandlern kompensiert und mit beispielsweise einer Software in der Transformatorüberwachungseinrichtung 30 korrigiert werden.

Die einzelnen Messvorrichtungen 5 können modular aufgebaut sein, um je nach Verwendungszweck die entsprechenden Anschlüsse für die entsprechenden Sensoren, wie z.B. die kapazitiven Sensoren 4 für die Durchführungen 2 oder die Mikrofone 16, 17, oder weitere Sensoren für eine Temperaturerfassung oder eine Druckerfassung aufzuweisen.

Das in Fig. 2 gezeigte System ermöglicht somit eine Überwachung von Durchführungen 2 von Transformatoren 1 im Betrieb, d.h. online, indem beispielsweise Kapazitäten, Verlustfaktoren und Teilentladungen der Durchführungen 2 gemessen werden. Weiterhin können die Übertragungsfunktion und das Teilentladungsverhalten der Wicklungen des Transformators 1 gemessen und bewertet werden. Somit können die wichtigsten elektrischen Parameter des Transformators 1 ständig überwacht werden. Die zuvor beschriebene Messvorrichtung 5, welche dicht am Fußpunkt der Durchführung 2 angebracht wird, stellt dabei eine hohe Messgenauigkeit der elektrischen Größen der Durchführung 2 sowie eine störungsfreie Übertragung der vorverarbeiteten elektrischen Größen zu der Transformatorüberwachungseinrichtung 30 sicher.

### BEZUGSZEICHENLISTE

- 1: Transformator
- 2: Durchführung
- 3: Hochspannungsleitung
- 4: Erfassungsmittel, Sensor
- 5: Messvorrichtung
- 6: Gehäuse außen
- 7: Gehäuse innen
- 8: Befestigungsmittel
- 9: Verarbeitungseinheit
- 10: Batterie
- 11: Sensoranschluss
- 12: Elektrode
- 13: Elektrodenanschluss
- 14,15: Mikrofonanschluss
- 16,17: Mikrofon
- 18: Datenübertragungsanschluss
- 19: Lichtwellenleiter
- 20: Signalgenerator
- 21: Erdungskabelanschluss
- 22-28: Kabelanschluss
- 29: Hochfrequenzstromübertrager
- 30: Transformatorüberwachungseinrichtung

## Patentansprüche

1. Messvorrichtung für einen Transformator, umfassend:
- ein Gehäuse (6, 7),
- eine Verarbeitungseinheit (9), welche in dem Gehäuse (6, 7) untergebracht ist,
- einen Anschluss (11) an dem Gehäuse (6, 7) zum Koppeln der Verarbeitungseinheit (9) mit einem Erfassungsmittel (4, 29) zum Erfassen einer elektrischen Größe an einem Anschluss (2, 21-28) des Transformators (1), und
- einen Datenübertragungsanschluss (18) zum Übertragen von Daten zwischen der Verarbeitungseinheit (9) und einer externen Transformatorüberwachungseinrichtung (30),
**dadurch gekennzeichnet, dass** die Messvorrichtung (5) eine Elektrode (12) umfasst, wobei die Elektrode (12) an einer Außenoberfläche des Gehäuses (6) der Messvorrichtung (5) derart angebracht ist, dass die Elektrode (12) bei Anbringen der Messvorrichtung (5) an dem Transformator (1) zusammen mit einer Hochspannungsleitung (3), welche mit dem Anschluss (2) des Transformators (1) gekoppelt ist, eine Kapazität bildet, wobei die Elektrode (12) von dem Gehäuse (6) galvanisch getrennt ist und mit der Verarbeitungseinheit (9) gekoppelt ist.

2. Messvorrichtung nach Anspruch 1, **dadurch gekennzeichnet, dass** die Messvorrichtung (5) Befestigungsmittel (8) zum Anbringen des Gehäuses (6, 7) an dem Transformator (1) umfasst.

3. Messvorrichtung nach Anspruch 1 oder 2, **dadurch gekennzeichnet, dass** die Datenübertragung zwischen der Verarbeitungseinheit (9) und der externen Transformatorüberwachungseinrichtung (30) eine optische Datenübertragung umfasst.

4. Messvorrichtung nach einem der vorhergehenden Ansprüche, **dadurch gekennzeichnet, dass** das Gehäuse (6, 7) der Messvorrichtung (5) elektromagnetisch geschirmt ist.

5. Messvorrichtung nach einem der vorhergehenden Ansprüche, **dadurch gekennzeichnet, dass** die Messvorrichtung (5) eine Energieversorgungseinheit (10) zum Versorgen der Messvorrichtung (5) mit elektrischer Energie umfasst.

6. Messvorrichtung nach einem der vorhergehenden Ansprüche, **dadurch gekennzeichnet, dass** die Messvorrichtung (5) einen Mikrofoneingang (15) zum Koppeln der Verarbeitungseinheit (9) mit einem an dem Transformator (1) angebrachten Mikrofon (17) umfasst.

7. Messvorrichtung nach einem der vorhergehenden Ansprüche, **dadurch gekennzeichnet, dass** die Messvorrichtung (5) einen Mikrofoneingang (14) zum Koppeln der Verarbeitungseinheit (9) mit einem an dem Anschluss (2, 21-28) des Transformators (1) angebrachten Mikrofon (16) umfasst.

8. Messvorrichtung nach einem der vorhergehenden Ansprüche, **dadurch gekennzeichnet, dass** die Messvorrichtung (5) einen Eingang für einen Öldrucksensor zum Koppeln der Verarbeitungseinheit (9) mit einem an dem Transformator (1) angebrachten Öldrucksensor umfasst.

9. Messvorrichtung nach einem der vorhergehenden Ansprüche, **dadurch gekennzeichnet, dass** der Anschluss des Transformators (1) eine Durchführung (2) durch ein Transformatorgehäuse des Transformators (1) umfasst, und dass das Erfassungsmittel (4) einen Messanschluss der Durchführung (2) zur Erfassung einer Kapazität an der Durchführung (2) umfasst.

10. Messvorrichtung nach einem der vorhergehenden Ansprüche, **dadurch gekennzeichnet, dass** der Anschluss des Transformators (1) eine Durchführung (2) durch ein Transformatorgehäuse des Transformators (1) umfasst, und dass das Erfassungsmittel (4) einen Metallbelag auf der Isolierung der Durchführung (2) zur Erfassung einer Kapazität an der Durchführung (2) umfasst.

11. Messvorrichtung nach einem der vorhergehenden Ansprüche, **dadurch gekennzeichnet, dass** der Anschluss des Transformators (1) eine Durchführung (2) durch ein Transformatorgehäuse des Transformators (1) umfasst, und dass die Verarbeitungseinheit (9) zur Bestimmung einer Kapazität, eines Verlustfaktors, einer Teilentladung und/oder einer Spannung der Durchführung (2) und/oder zur Bestimmung eines Stromes durch die Durchführung (2) ausgestaltet ist.

12. Messvorrichtung nach einem der vorhergehenden Ansprüche, **dadurch gekennzeichnet, dass** der Anschluss des Transformators (1) einen Kabelanschluss (21-28) des Transformators (1) umfasst, und dass das Erfassungsmittel (29) einen Hochfrequenzstromübertrager umfasst, welcher mit einem an dem Kabelanschluss (21-28) des Transformators (1) angeschlossenen Kabel gekoppelt ist.

13. Messvorrichtung nach einem der vorhergehenden Ansprüche, **dadurch gekennzeichnet, dass** die Messvorrichtung (5) einen Signalgenerator (20) zum Einspeisen eines Prüfsignals in den Transformator (1) umfasst.

14. System zum Überwachen eines Transformators, welcher mehrere Anschlüsse (2, 21-28) umfasst, wobei das System umfasst:
- mehrere Messvorrichtungen (5) nach einem der vorhergehenden Ansprüche, wobei jede Messvorrichtung (5) benachbart zu jeweils einem Anschluss (2, 21-28) des Transformators (1) anzuordnen ist, und
- eine Transformatorüberwachungseinrichtung (30), welche mit den mehreren Messvorrichtungen (5) gekoppelt ist und ausgestaltet ist, aus einer Kombination der Daten von den mehreren Messvorrichtungen (5) einen aktuellen Zustand des Transformators (1) zu bestimmen.

15. System nach Anspruch 14, **dadurch gekennzeichnet, dass** der aktuelle Zustand eine Nennübersetzung des Transformators (1), eine Leistung des Transformators (1), eine Kurzschlussimpedanz des Transformators (1), eine Übertragungsfunktion einer Wicklung des Transformators (1), eine Teilentladung in dem Transformator (1) und/oder eine Teilentladung an einem der mehreren Anschlüsse (2, 21-28) umfasst.

16. System nach Anspruch 14 oder 15, **dadurch gekennzeichnet, dass** die mehreren Anschlüsse des Transformators Phasenanschlüsse (2, 22-24, 26-28) des Transformators (1) und einen Mittelpunktsleiter (21, 25) des Transformators (1) umfassen.

17. System nach einem der Ansprüche 14-16, **dadurch gekennzeichnet, dass** die Transformatorüberwachungseinrichtung (30) mit den mehreren Messvorrichtungen (5) über optische Datenübertragungsleitungen gekoppelt ist.

18. Verfahren zum Überwachen eines Transformators, wobei das Verfahren umfasst:
- Erfassen einer elektrische Größe an einem Anschluss (2, 21-28) des Transformators (1),
- Vorverarbeiten der erfassten elektrischen Größe in einer Messvorrichtung (5), welche benachbart zu dem Anschluss (2, 21-28) angeordnet wird,
- Übertragen von Daten der vorverarbeiteten elektrischen Größe von der Messvorrichtung (5) an eine Transformatorüberwachungseinrichtung (30), und
- Bestimmen eines aktuellen Zustand des Transformators (1) in der Transformatorüberwachungseinrichtung (30) aus den übertragenen Daten,
**dadurch gekennzeichnet, dass** die elektrische Größe eine Kapazität zwischen einer Elektrode (12) und einer Hochspannungsleitung (3), welche mit dem Anschluss (2) des Transformators (1) gekoppelt ist, umfasst, wobei die Elektrode (12) an einer Außenoberfläche eines Gehäuses (6) der Messvorrichtung (5) der Hochspannungsleitung (3) gegenüberliegend angebracht ist.

19. Verfahren nach Anspruch 18, **dadurch gekennzeichnet, dass** die elektrische Größe eine Kapazität an dem Anschluss (2, 21-28) des Transformators (1) umfasst.

20. Verfahren nach einem der Ansprüche 18 oder 19, **dadurch gekennzeichnet, dass** die Messvorrichtung (5) eine Messvorrichtung (5) nach einem der Ansprüche 1-13 umfasst.

21. Verfahren nach einem der Ansprüche 18-20, **dadurch gekennzeichnet, dass** das Übertragen der Daten von der Messvorrichtung (5) zu der Transformatorüberwachungseinrichtung (30) über optische Datenübertragungsleitungen erfolgt.

22. Verfahren nach einem der Ansprüche 18-21, **dadurch gekennzeichnet,**
**dass** mehrere Messvorrichtungen (5) an mehreren Anschlüssen (2, 21-28) des Transformators (1) anzuordnen sind,
**dass** die mehreren Messvorrichtungen (5) jeweils Daten von jeweils vorverarbeiteten elektrischen Größen an die zentrale Transformatorüberwachungseinrichtung (30) übertragen, und
**dass** die Transformatorüberwachungseinrichtung (30) aus einer Kombination der Daten von den mehreren Messvorrichtungen (5) einen aktuellen Zustand des Transformators (1) bestimmt.

## Claims

1. Measuring device for a transformer, comprising:
- a housing (6, 7),
- a processing unit (9), which is housed in the housing (6, 7),
- a terminal (11) at the housing (6, 7) for connecting the processing unit (9) to a sensing means (4, 29) to sense an electrical magnitude at a terminal (2, 21-28) of the transformer (1), and
- a data transmission terminal (18) for transmitting data between the processing unit (9) and an external transformer monitoring device (30),
**characterized in that**
the measuring device (5) comprises an electrode (12), the electrode (12) being attached to an outer surface of the housing (6) of the measuring device (5) in such a way that, when the measuring device (5) is attached to the transformer (1), the electrode (12), together with a high voltage line (3), which is connected to the terminal (2) of the transformer (1), forms a capacitance, the electrode (12) being galvanically disconnected from the housing (6) and connected to the processing unit (9).

2. Measuring device according to Claim 1,
**characterized in that** the measuring device (5) comprises fixing means (8) for attaching the housing (6, 7) to the transformer (1).

3. Measuring device according to Claim 1 or 2,
**characterized in that** the data transmission between the processing unit (9) and the external transformer monitoring device (30) comprises optical data transmission.

4. Measuring device according to any one of the preceding claims,
**characterized in that** the housing (6, 7) of the measuring device (5) is electromagnetically screened.

5. Measuring device according to any one of the preceding claims,
**characterized in that** the measuring device (5) includes a power supply unit (10) for supplying electrical energy to the measuring device (5).

6. Measuring device according to any one of the preceding claims,
**characterized in that** the measuring device (5) comprises a microphone input (15) for coupling the processing unit (9) to a microphone (17) which is attached to the transformer (1).

7. Measuring device according to any one of the preceding claims,
**characterized in that** the measuring device (5) comprises a microphone input (14) for coupling the processing unit (9) to a microphone (16) which is attached to the terminal (2, 21-28) of the transformer (1).

8. Measuring device according to any one of the preceding claims,
**characterized in that** the measuring device (5) comprises an input for an oil pressure sensor for coupling the processing unit (9) to an oil pressure sensor which is attached to the transformer (1).

9. Measuring device according to any one of the preceding claims,
**characterized in that** the terminal of the transformer (1) includes a bushing (2) through a transformer housing of the transformer (1), and that the sensing means (4) comprises a measuring terminal of the bushing (2) for sensing a capacitance at the bushing (2).

10. Measuring device according to any one of the preceding claims,
**characterized in that** the terminal of the transformer (1) comprises a bushing (2) through a transformer housing of the transformer (1), and that the sensing means (4) comprises a metal lining on an insulation of the bushing (2) for sensing a capacitance on the bushing (2).

11. Measuring device according to any one of the preceding claims,
**characterized in that** the terminal of the transformer (1) comprises a bushing (2) through a transformer housing of the transformer (1), and that the processing unit (9) is designed to determine a capacitance, a loss factor, a partial discharge and/or a voltage of the bushing (2), and/or to determine a current through the bushing (2).

12. Measuring device according to any one of the preceding claims,
**characterized in that** the terminal of the transformer (1) comprises a cable terminal (21-28) of the transformer (1), and that the sensing means (29) comprises a high frequency current transmitter, which is coupled to a cable, which is connected to the cable terminal (21-28) of the transformer (1).

13. Measuring device according to any one of the preceding claims,
**characterized in that** the measuring device (5) comprises a signal generator (20) for feeding a test signal into the transformer (1).

14. System for monitoring a transformer which comprises multiple terminals (2, 21-28), the system comprising:
- multiple measuring devices (5) according to any one of the preceding claims, each measuring device (5) having to be arranged adjacently to a terminal (2, 21-28) of the transformer (1), and
- a transformer monitoring device (30), which is connected to the multiple measuring devices (5), and is designed to determine, from a combination of the data from the multiple measuring devices (5), a present state of the transformer (1).

15. System according to Claim 14,
**characterized in that** the present state comprises a rated transformation ratio of the transformer (1), a power of the transformer (1), a short circuit impedance of the transformer (1), a transfer function of a winding of the transformer (1), a partial discharge in the transformer (1) and/or a partial discharge on one of the multiple terminals (2, 21-28).

16. System according to Claim 14 or 15,
**characterized in that** the multiple terminals of the transformer include phase terminals (2, 22-24, 26-28) of the transformer (1) and a neutral conductor (21, 25) of the transformer (1).

17. System according to any one of Claims 14-16, **characterized in that** the transformer monitoring device (30) is connected to the multiple measuring devices (5) via optical data transmission lines.

18. Method for monitoring a transformer, the system comprising:
- sensing an electrical magnitude at a terminal (2, 21-28) of the transformer (1),
- preprocessing the sensed electrical magnitude in a measuring device (5), which is arranged adjacently to the terminal (2, 21-28),
- transmitting data of the preprocessed electrical magnitude from the measuring device (5) to a transformer monitoring device (30), and
- in the transformer monitoring device (30), determining a present state of the transformer (1) from the transmitted data,
**characterized in that**
the electrical magnitude comprises a capacitance between an electrode (12) and a high voltage line (3) which is coupled to the terminal (2) of the transformer (1), the electrode (12) being attached at an outer surface of a housing (6) of the measuring device (5) of the high voltage line (3).

19. Method according to Claim 18,
**characterized in that** the electrical magnitude comprises a capacitance at the terminal (2, 21-28) of the transformer (1).

20. Method according to Claim 18 or Claim 19,
**characterized in that** the measuring device (5) comprises a measuring device (5) according to any one of Claims 1-13.

21. Method according to any one of Claims 18-20,
**characterized in that** the data are transmitted from the measuring device (5) to the transformer monitoring device (30) via optical data transmission lines.

22. Method according to any one of Claims 18-21,
**characterized in that**
multiple measuring devices (5) are to be arranged at multiple terminals (2, 21-28) of the transformer (1),
the multiple measuring devices (5) each transmit data of preprocessed electrical magnitudes to the central transformer monitoring device (30), and the transformer monitoring device (30) determines, from a combination of the data from the multiple measuring devices (5), a present state of the transformer (1).

## Revendications

1. Dispositif de mesure pour un transformateur, comportant :
- un boîtier (6, 7),
- une unité de traitement (9), qui est logée dans le boîtier (6, 7),
- une borne de raccordement (11) sur le boîtier (6, 7) destinée au couplage de l'unité de traitement (9) avec un moyen de détection (4, 29) destiné à détecter une grandeur électrique en une borne de raccordement (2, 21-28) du transformateur (1), et
- une borne de transmission de données (18) destinée à la transmission de données entre l'unité de traitement (9) et un dispositif de surveillance du transformateur (30) externe,
**caractérisé en ce que** le dispositif de mesure (5) comporte une électrode (12), l'électrode (12) étant disposée sur une surface externe du boîtier (6) du dispositif de mesure (5) de manière telle que l'électrode (12) forme une capacité lors du montage du dispositif de mesure (5) sur le transformateur (1) conjointement avec une ligne à haute tension (3) qui est couplée à la borne de raccordement (2) du transformateur (1), l'électrode (12) étant isolée galvaniquement du boîtier (6) et couplée à l'unité de traitement (9).

2. Dispositif de mesure selon la revendication 1, **caractérisé en ce que** le dispositif de mesure (5) comporte des moyens de fixation (8) pour monter le boîtier (6, 7) sur le transformateur (1).

3. Dispositif de mesure selon la revendication 1 ou 2, **caractérisé en ce que** la transmission de données entre l'unité de traitement (9) et le dispositif de surveillance du transformateur (30) externe comporte une transmission de données optique.

4. Dispositif de mesure selon l'une quelconque des revendications précédentes, **caractérisé en ce que** le boîtier (6, 7) du dispositif de mesure (5) comporte un blindage électromagnétique.

5. Dispositif de mesure selon l'une quelconque des revendications précédentes, **caractérisé en ce que** le dispositif de mesure (5) comporte une unité d'alimentation en énergie (10) destinée à alimenter le dispositif de mesure (5) en énergie électrique.

6. Dispositif de mesure selon l'une quelconque des revendications précédentes, **caractérisé en ce que** le dispositif de mesure (5) comporte une entrée de microphone (15) destinée à coupler l'unité de traitement (9) à un microphone (17) monté sur le transformateur (1).

7. Dispositif de mesure selon l'une quelconque des revendications précédentes, **caractérisé en ce que** le dispositif de mesure (5) comporte une entrée de microphone (14) destinée à coupler l'unité de traitement (9) à un microphone (16) raccordé à la borne de raccordement (2, 21-28) du transformateur (1).

8. Dispositif de mesure selon l'une quelconque des revendications précédentes, **caractérisé en ce que** le dispositif de mesure (5) comporte une entrée pour un capteur de pression d'huile destiné à coupler l'unité de traitement (9) à un capteur de pression d'huile monté sur le transformateur (1).

9. Dispositif de mesure selon l'une quelconque des revendications précédentes, **caractérisé en ce que** la borne de raccordement du transformateurs (1) comporte une traversée (2) à travers un boîtier du transformateur (1), et **en ce que** le moyen de détection (4) comporte une borne de mesure de la traversée (2) destinée à détecter une capacité sur la traversée (2).

10. Dispositif de mesure selon l'une quelconque des revendications précédentes, **caractérisé en ce que** la borne de raccordement du transformateur (1) comporte une traversée (2) à travers un boîtier du transformateur (1), et **en ce que** le moyen de détection (4) comporte une métallisation sur l'isolation de la traversée (2) destinée à détecter une capacité sur la traversée (2).

11. Dispositif de mesure selon l'une quelconque des revendications précédentes, **caractérisé en ce que** la borne de raccordement du transformateur (1) comporte une traversée (2) à travers un boîtier transformateur (1), et **en ce que** l'unité de traitement (9) est conçue pour déterminer une capacité, un facteur de pertes, une charge partielle et/ou une tension de la traversée (2) et/ou pour déterminer un courant à travers la traversée (2).

12. Dispositif de mesure selon l'une quelconque des revendications précédentes, **caractérisé en ce que** la borne de raccordement du transformateur (1) comporte un raccord de câble (21-28) du transformateur (1), et **en ce que** le moyen de détection (29) comporte un dispositif de transfert de courant à haute fréquence qui est couplé avec un câble branché sur le raccord de câble (21-28) du transformateur (1).

13. Dispositif de mesure selon l'une quelconque des revendications précédentes, **caractérisé en ce que** le dispositif de mesure (5) comporte un générateur de signaux (20) destiné à injecter un signal d'essai dans le transformateur (1).

14. Système de surveillance d'un transformateur qui comporte plusieurs bornes de raccordement (2, 21-28), le système comportant :
- plusieurs dispositifs de mesure (5) selon l'une quelconque des revendications précédentes, chaque dispositif de mesure (5) étant disposé à côté respectivement d'une borne de raccordement (2, 21-28) du transformateur (1), et
- un dispositif de surveillance du transformateur (30) qui est couplé aux plusieurs dispositifs de mesure (5) et est conçu pour déterminer un état actuel du transformateur (1) à partir d'une combinaison des données des plusieurs dispositifs de mesure (5).

15. Système selon la revendication 14, **caractérisé en ce que** l'état actuel comporte un rapport de transformation nominal du transformateur (1), une puissance du transformateur (1), une impédance de court-circuit du transformateur (1), une fonction de transfert d'un enroulement du transformateur (1), une charge partielle dans le transformateur (1) et/ou une charge partielle sur une des multiples bornes de raccordement (2, 21-28).

16. Système selon la revendication 14 ou 15, **caractérisé en ce que** les multiples bornes de raccordement du transformateur comportent des bornes de phase (2, 22-24, 26-28) du transformateur (1) et un conducteur de point neutre (21, 25) du transformateur (1).

17. Système selon l'une des revendications 14 à 16, **caractérisé en ce que** le dispositif de surveillance du transformateur (30) est couplé aux multiples dispositifs de mesure (5) par le biais de lignes optiques de transmission de données.

18. Procédé de surveillance d'un transformateur, le procédé consistant à :
- détecter une grandeur électrique sur une borne de raccordement (2, 21-28) du transformateur (1),
- prétraiter la grandeur électrique détectée dans un dispositif de mesure (5) qui est disposé au voisinage de la borne de raccordement (2, 21-28),
- transmettre les données de la grandeur électrique prétraitée du dispositif de mesure (5) à un dispositif de surveillance du transformateur (30), et
- déterminer un état actuel du transformateur (1) dans le dispositif de surveillance du transformateur (30) à partir des données transmises,
**caractérisé en ce que** la grandeur électrique comporte une capacité entre une électrode (12) et une ligne à haute tension (3) qui est couplée à la borne de raccordement (2) du transformateur (1), l'électrode (12) étant montée sur une surface externe d'un boîtier (6) du dispositif de mesure (5) en regard de la ligne à haute tension (3).

19. Procédé selon la revendication 18, **caractérisé en ce que** la grandeur électrique comporte une capacité sur la borne de raccordement (2, 21-28) du transformateur (1).

20. Procédé selon l'une des revendications 18 ou 19, **caractérisé en ce que** le dispositif de mesure (5) comporte un dispositif de mesure (5) selon l'une des revendications 1 à 13.

21. Procédé selon l'une des revendications 18 à 20,
**caractérisé en ce que** la transmission des données du dispositif de mesure (5) au dispositif de surveillance du transformateur (30) est effectuée par le biais de lignes optiques de transmission de données.

22. Procédé selon l'une des revendications 18 à 21, **caractérisé**
**en ce que** plusieurs dispositifs de mesure (5) doivent être affectés à plusieurs bornes de raccordement (2, 21-28) du transformateur (1),
**en ce que** les plusieurs dispositifs de mesure (5) transmettent respectivement des données de grandeurs électriques respectivement prétraitées au dispositif central de surveillance du transformateur (30), et
**en ce que** le dispositif de surveillance du transformateur (30) détermine un état actuel du transformateur (1) à partir d'une combinaison des données de plusieurs dispositifs de mesure (5).
